# FASCICULE DE BREVET EUROPEEN

(11) **EP 3 240 374 B1**
(45) Date de publication et mention de la délivrance du brevet: **19.08.2020**
(21) Numéro de dépôt: 17168338.6
(22) Date de dépôt: 27.04.2017
(51) Int. Cl.: H05K 5/00

(54) **BOITIER DE COMMANDE ET/OU D'AFFICHAGE POUR APPAREIL ELECTROMENAGER, APPAREIL ELECTROMENAGER COMPORTANT UN TEL BOITIER ET PROCEDE D'ASSEMBLAGE D'UN TEL BOITIER**
STEUER- UND/ODER ANZEIGEGEHÄUSE FÜR ELEKTROHAUSHALTSGERÄT, ELEKTROHAUSHALTSGERÄT, DAS EIN SOLCHES GEHÄUSE UMFASST, UND ZUSAMMENBAUVERFAHREN EINES SOLCHEN GEHÄUSES
CONTROL AND/OR DISPLAY HOUSING FOR AN ELECTRIC HOUSEHOLD APPLIANCE, ELECTRIC HOUSEHOLD APPLIANCE COMPRISING SUCH A HOUSING AND METHOD FOR ASSEMBLING SUCH A HOUSING

(30) Priorité: 29.04.2016 FR 1653913
(43) Date de publication de la demande: 01.11.2017
(73) Titulaire: Groupe Brandt, 92500 Rueil-Malmaison (FR)
(72) Inventeur: DIAZ, Esteban, 45140 Ingre (FR); SILVA, Adrien, 41220 Saint Laurent Nouan (FR)
(74) Mandataire: Santarelli

(56) Documents cités:
- WO-A2-2013/079675
- US-A1- 2002 179 599
- US-A1- 2007 205 011
- US-A1- 2016 014 911
- US-B1- 7 531 744

## Description

La présente demande concerne un boîtier de commande et/ou d'affichage, par exemple en plastique, pour tous appareils électroménagers. Elle concerne également un appareil électroménager comportant un tel boîtier ainsi qu'un procédé d'assemblage d'un tel boîtier.

Les boîtiers, de commande et/ou d'affichage, actuels comportent typiquement, au moins, un support plastique, une carte électronique (également désignée par « PCB » pour *printed circuit board* ou carte de circuits imprimés), un écran d'affichage et/ou un clavier de commande, et des pièces indépendantes telles que, notamment, des ressorts métalliques, des vis ou d'autres.

Pour assembler un tel boîtier, un opérateur dispose alors de plusieurs bacs d'approvisionnement qui comportent les différents éléments d'assemblage et effectue l'assemblage du boîtier selon une notice de montage en utilisant les éléments disponibles dans les bacs d'approvisionnement.

Or, les ressorts et vis, par exemple, sont des pièces rapportées à l'ensemble formant le boîtier et sont généralement commandés auprès de fournisseurs distincts. Un défaut d'approvisionnement d'un seul de ces éléments peut donc entrainer l'arrêt complet du montage du boîtier.

De plus, gérer des pièces séparées impose un référencement et une gestion sur ligne complexe.

Par ailleurs, il est facilement possible d'oublier un élément lors du montage du boîtier.

Au moins un des objectifs de la présente demande est ainsi de résoudre, au moins en partie, les inconvénients précités, en menant en outre à d'autres avantages.

La présente demande vise en particulier à rendre plus ergonomique et/ou intuitif l'assemblage d'un tel boîtier.

A cet effet, est proposé selon un premier aspect, un boîtier de commande et/ou d'affichage pour appareil électroménager comportant au moins un support comportant un cadre de référence, le boîtier étant caractérisé en ce que :
- dans un premier état, le support comporte au moins un élément dit « détachable », l'élément détachable comportant au moins une base reliée, en un premier emplacement, au cadre de référence par au moins un pont de matière formant une patte cassable, et en ce que
- dans un deuxième état, l'élément détachable est positionné à un deuxième emplacement, ménagé dans le cadre de référence du support, distinct du premier emplacement.

En d'autres termes, de sorte à être « détachable », un tel élément comporte au moins une base reliée au cadre de référence par au moins un pont de matière formant une patte cassable, aussi appelée parfois pédoncule. Le pont de matière est donc d'épaisseur moindre qu'une épaisseur de la base et d'une portion du cadre de référence à laquelle il est directement relié par exemple.

De tels éléments sont ainsi qualifiés de « détachable » car ils permettent de les détacher sans difficulté, par exemple en cassant à la main les pattes cassables.

Dans ce premier état, chaque élément détachable est donc, par définition, à son premier emplacement, relié au cadre de référence.

Ainsi, le support est dans son premier état lorsqu'au moins un élément détachable est relié au cadre de référence.

Un tel support rend ainsi l'assemblage du boîtier plus ergonomique et intuitif, par comparaison avec un assemblage traditionnel, grâce à l'utilisation d'un support comportant initialement des pièces nécessaires à son assemblage sous forme d'éléments détachables.

Dans un exemple de réalisation particulier, les éléments détachables sont disposés, dans le premier état du boîtier, de sorte qu'il est impossible de procéder à l'assemblage complet du boîtier, voire à son utilisation, sans avoir détaché l'intégralité des éléments détachables.

Une telle disposition permet ainsi d'éviter d'oublier un élément détachable et limite ainsi les mauvais assemblages.

A cet effet, les éléments détachables, à leur premier emplacement, sont par exemple disposés afin d'obstruer un logement dédié à au moins une partie d'une interface avec un utilisateur, par exemple un logement configuré pour recevoir un écran ou un clavier de commande lorsque le boîtier est monté, c'est-à-dire dans un état final. Autrement dit, il n'est par exemple pas possible de disposer intégralement l'interface avec un utilisateur dans le support du boîtier tant que tous les éléments détachables n'ont pas été retirés du cadre de référence.

Selon un autre exemple, une zone obstruée par l'élément détachable évite par exemple de pouvoir monter la carte de circuits imprimés. Par exemple l'élément détachable bloque un accès à au moins une partie du logement de la carte de circuits imprimés, de sorte qu'il n'est pas possible de la positionner dans son logement, ou bloque un accès à au moins une partie de la carte de circuits imprimés si celle-ci est positionnée de sorte qu'elle ne peut pas être utilisée.

Ainsi, par exemple, le premier emplacement d'au moins un élément détachable est ménagé dans une partie d'un logement de réception d'une interface avec un utilisateur et/ou dans une partie d'un logement de réception d'une carte de circuits imprimés, le premier emplacement étant ainsi configuré pour interdire un assemblage complet du boîtier lorsqu'au moins un élément détachable est à son premier emplacement.

Selon un exemple de réalisation, le support comporte au moins une fenêtre, configurée pour y positionner en vis-à-vis au moins une partie d'une interface avec un utilisateur, et le premier emplacement est ménagé dans ladite fenêtre.

La partie de l'interface utilisateur comporte par exemple un écran d'affichage et/ou un clavier qui, par exemple, comporte au moins une touche de commande.

Dans un cas particulier, dans le premier état, ladite fenêtre est obstruée par un ensemble de base, l'ensemble de base étant formé d'au moins la base de l'au moins un élément détachable.

Le boîtier dans le premier état est ainsi configuré pour interdire son assemblage et/ou son utilisation tant que tous les éléments détachables ne sont pas détachés.

Par exemple, le cadre de référence comporte un décrochement, par exemple une rainure ou une empreinte, configuré pour coopérer avec une partie d'un élément détachable, formant un indicateur de positionnement de l'élément détachable dans le cadre de référence à son deuxième emplacement.

Dans un exemple de réalisation intéressant, la base de l'élément détachable comporte un décrochement et le deuxième emplacement est défini, au moins en partie, par le décrochement formé dans le cadre de référence, de forme complémentaire du décrochement de la base de l'élément détachable, le décrochement du cadre de référence étant configuré pour coopérer avec le décrochement de l'élément détachable, formant un indicateur de positionnement de l'élément détachable dans le cadre de référence à son deuxième emplacement.

Le boîtier est encore plus facilement assemblé en optimisant le montage grâce à la présence de tels indicateurs formés dans le support.

Il est ainsi possible de réduire davantage les coûts de fabrication.

Dans un exemple de réalisation particulièrement avantageux, tous les éléments ressorts et/ou de solidarisation nécessaires sont réalisés dans le support.

Par exemple, les éléments ressorts sont détachables du cadre de référence du support afin d'être positionnés à un autre emplacement. Autrement dit, les éléments détachables sont de préférence des éléments de type ressort.

Par exemple, les vis d'assemblage sont remplacées par des clips solidaires du cadre de référence du support, voire intégrés dans le cadre de référence du support.

Un clip est par exemple un élément déformable élastique comportant une gorge.

Il se présente par exemple sous une forme de harpon muni d'une gorge.

Ainsi, selon un mode de réalisation particulier, l'élément détachable est un élément ressort comportant une plaquette et au moins une lame élastique, la lame élastique étant reliée à la plaquette et ayant au moins une partie disposée à distance de la plaquette, la plaquette formant la base de l'élément détachable.

Une telle lame est occasionnellement également qualifiée de lame en attente lorsque la partie disposée à distance de la plaquette est une extrémité libre de la lame élastique.

Selon un autre mode de réalisation particulier, le cadre de référence comporte un logement de réception d'une carte de circuits imprimés, le logement étant formé par au moins un clip constitué d'un élément déformable élastiquement comportant une gorge configurée pour y insérer la carte de circuits imprimés.

La carte de circuits imprimés est ainsi facilement fixée dans le support, et plus particulièrement dans ce cas dans le cadre de référence.

Dans un exemple de réalisation, le boîtier comporte en outre, dans un état final, une interface avec un utilisateur et une carte de circuits imprimés.

Par exemple, au moins une partie de l'interface avec un utilisateur, les bases des éléments détachables et la carte de circuits imprimés sont alors disposés sensiblement parallèlement les unes aux autres.

Par exemple, la carte de circuits imprimés est disposée dans le logement de réception correspondant.

Par exemple, l'interface avec un utilisateur est disposée au moins en partie en vis-à-vis d'une fenêtre formée dans le cadre de référence.

Par exemple, au moins un élément détachable, en son deuxième emplacement, est positionné entre l'interface avec un utilisateur et la carte de circuits imprimés.

Est également proposé, selon un deuxième aspect, un appareil électroménager qui comporte un boîtier comportant tout ou partie des caractéristiques décrites précédemment.

Il s'agit par exemple d'une machine à laver le linge, ou d'une machine à laver et sécher le linge, ou d'un four, ou encore d'une plaque de cuisson.

Le boîtier est par exemple positionné en partie frontale supérieure de l'appareil ou dans une zone proximale de l'appareil, c'est-à-dire une zone destinée à être orientée au plus près d'un utilisateur.

Est également proposé, selon un troisième aspect, un procédé d'assemblage d'un boîtier comportant tout ou partie des caractéristiques décrites précédemment, le procédé comportant :
- Une étape de fourniture d'un support comportant un cadre de référence et un élément détachable par rapport au cadre de référence, l'élément détachable étant relié au cadre de référence par au moins un pont de matière formant une patte cassable ;
- Une étape de détachement de chacun des au moins un élément détachable du cadre de référence ; et
- Une étape d'insertion de chacun des au moins un élément détachable dans un deuxième emplacement respectif ménagé dans le cadre de référence.

Selon une option envisageable, l'étape d'insertion de chacun des au moins un élément détachable dans un deuxième emplacement respectif est effectuée en plaçant une base de l'au moins un élément détachable en appui plan contre une face arrière d'une partie d'une interface avec un utilisateur.

Dans un exemple de mise en œuvre, le procédé comporte en outre, après l'étape de détachement de chacun des au moins un élément détachable du cadre de référence :
- Une étape de disposition d'une interface avec un utilisateur dans un logement correspondant ménagé dans le cadre de référence ; et
- Une étape de placement d'une carte de circuits imprimés dans un logement de réception d'une carte de circuits imprimés ménagé dans le cadre de référence du support, au moins un élément détachable, à son deuxième emplacement, étant positionné entre l'interface avec un utilisateur et la carte de circuits imprimés.

Eventuellement, la carte de circuits imprimés est placée en appui contre au moins une partie de l'au moins un élément détachable.

Selon un exemple de mise en œuvre, l'étape de placement de la carte de circuits imprimés comporte une étape d'application, à la carte de circuits imprimés, d'un effort d'enfoncement pour déformer la, ou les, lame(s) élastique(s) d'un élément détachable de type ressort et les clips, jusqu'à ce que la carte de circuits imprimés soit insérée dans la gorge de chaque clip et que chaque clip reprenne sa position initiale.

En outre, le support est possiblement réalisé par injection plastique, et ce, par exemple, en polycarbonate, en PC/ABS (Polycarbonate/Acrylonitrile Butadiène Styrène), en polyamide ou tout autre matériau plastique approprié pour l'injection de pièces. De tels matériaux présentent à la fois des propriétés mécaniques, électriques (non conductrice) et une résistance thermique appropriées.

Ainsi, en d'autres termes, sur chaine de montage, un opérateur détache les éléments détachables, par exemple les éléments de type ressort du cadre de référence, puis dispose une partie de l'interface, par exemple l'écran d'affichage, dans son logement et insère les éléments ressorts dans des emplacements destinés à les recevoir, c'est-à-dire leur deuxième emplacement respectif, et par exemple jusqu'à ce que ces derniers soient en appui plan contre la face arrière de la partie de l'interface préalablement positionnée.

L'opérateur insère la carte de circuits imprimés qui vient par exemple en appui, d'une part contre les lames élastiques et d'autre part contre les clips. L'opérateur applique à la carte de circuits imprimés un effort suffisant pour déformer les lames élastiques et les clips, jusqu'à ce que la carte de circuits imprimés s'insère dans la gorge des clips et que ces derniers reprennent leur position initiale.

Grâce à un tel boîtier, tous les éléments ressorts et/ou de solidarisation peuvent être réalisés sur une même pièce, le support. Avantageusement, les éléments ressorts sont détachables afin d'être positionnés à un autre emplacement. Au moins les vis d'assemblage du boîtier pour maintenir la carte de circuits imprimés sont de préférences remplacées par des clips solidaires du cadre de référence.

Le procédé comporte aussi possiblement une étape de connexion de l'écran et la carte de circuits imprimés, par exemple au moyen d'une nappe de connexion.

Ultérieurement, le boîtier est par exemple possiblement monté dans un appareil électroménager.

L'invention, selon un exemple de réalisation, sera bien comprise et ses avantages apparaitront mieux à la lecture de la description détaillée qui suit, donnée à titre indicatif et nullement limitatif, en référence aux dessins annexés dans lesquels :
La figure 1 montre une vue en perspective d'un côté externe d'un support de boîtier selon un exemple de réalisation, dans un premier état, le support comportant des éléments détachables de type ressort à leur premier emplacement,
La figure 2 montre, en perspective, le détail II de la figure 1 en illustrant en outre un positionnement relatif d'une carte de circuits imprimés comportant des boutons qui sont alors masqués par les éléments détachables,
La figure 3 montre une vue en perspective d'un côté interne du support de boîtier de la figure 1, dans son premier état,
La figure 4 montre le support de boîtier présenté selon la même vue que celle de la figure 3 avec les éléments détachables retirés de leur premier emplacement,
Les figures 5a et 5b montrent un élément détachable de type ressort selon un exemple de réalisation,
La figure 6 montre le support de boîtier présenté selon la même vue que celle des figures 3 et 4, dans un deuxième état selon un exemple de réalisation, avec les éléments détachables placés à leur deuxième emplacement,
La figure 7 présente schématiquement une coupe d'un boîtier, comportant le support représenté sur les figures 1 à 6, dans un état final selon un exemple de réalisation, et
La figure 8 montre le boîtier présenté selon la même vue que celle des figures 3, 4 et 6, dans l'état final de la figure 7.

Les éléments identiques représentés sur les figures précitées sont identifiés par des références numériques identiques.

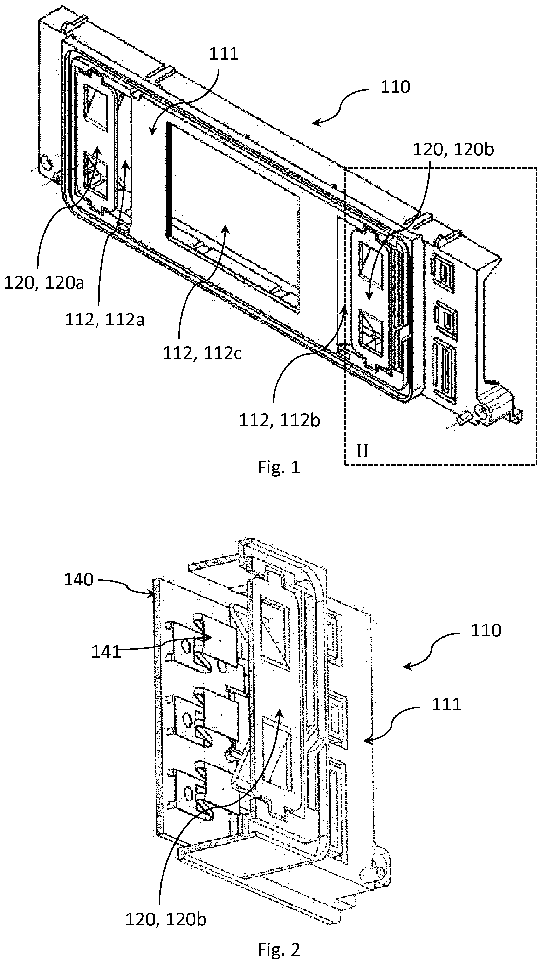

La figure 1 présente un support 110 de boîtier 100 selon un exemple de réalisation présenté d'un côté externe.

Le support est par exemple réalisé par injection plastique, par exemple en polycarbonate ou en PC/ABS (Polycarbonate/Acrylonitrile Butadiène Styrène), en polyamide ou tout autre matériau plastique approprié pour l'injection de pièces.

Le support 110 comporte principalement un cadre de référence 111.

Le cadre de référence 111 comporte par exemple au moins des éléments standards de support de boîtier habituel.

En outre, ces éléments sont avantageusement formés d'une seule pièce, c'est-à-dire de manière monobloc.

Dans le présent exemple de réalisation, le support se présente principalement sous la forme d'une plaque munie de différents renforts de rigidité et d'éléments d'accrochage pour ultérieurement fixer le boîtier, en particulier dans un appareil électroménager.

Le support 110 comporte au moins une fenêtre 112. Une fenêtre 112 est destinée à permettre à un utilisateur d'interagir avec une interface 130 positionnée d'un côté interne du support une fois le boîtier assemblé.

L'interface avec un utilisateur 130 comporte par exemple un écran 132 et/ou un clavier 131 (présentés ultérieurement), c'est-à-dire au moins une touche, permettant à l'utilisateur de contrôler et/ou régler l'appareil électroménager auquel le boîtier est destiné.

Ici, il y a trois fenêtres 112 qui sont trois ouvertures rectangulaires juxtaposées.

L'une des fenêtres 112, ici la fenêtre centrale 112c, est configurée pour y loger un écran 132.

Deux autres des fenêtres 112, ici une première et une deuxième fenêtre latérale 112a et 112b, disposées de part et d'autre de la fenêtre centrale 112c, sont configurées pour recevoir d'autres parties d'une interface avec un utilisateur 130, par exemple un clavier comportant des touches de commande.

Bien entendu, le support pourrait ne comporter qu'une seule fenêtre, ou deux fenêtres ou plus de trois. Et l'interface avec un utilisateur 130 peut être positionnée en vis-à-vis de la, ou les, fenêtre(s) en étant constituée d'une seule partie ou de plusieurs, par exemple d'autant de parties qu'il y a de fenêtres ou d'une seule partie pour une seule ou plusieurs fenêtres.

Comme l'illustre la figure 1, lorsque le support est dans un premier état, il comporte en outre au moins un élément détachable 120, ici deux éléments détachables 120a, 120b, reliés au cadre de référence.

Les deux éléments détachables représentés sont ici identiques mais il pourrait en être autrement.

De sorte à être « détachable », un tel élément comporte au moins une base reliée au cadre de référence par au moins un pont de matière formant une patte cassable. Le pont de matière est donc d'épaisseur moindre qu'une épaisseur de la base et d'une portion du cadre de référence à laquelle il est directement relié par exemple.

De tels éléments sont ainsi qualifiés de « détachable » car ils peuvent être facilement séparés du cadre de référence, par exemple en cassant à la main les pattes cassables.

Dans ce premier état, chaque élément détachable est donc, par définition, à son premier emplacement et relié au cadre de référence.

Autrement dit, le support est dans son premier état lorsqu'au moins un élément détachable est relié au cadre de référence.

Dans le présent exemple de réalisation, un premier élément détachable 120a est à son premier emplacement dans la première fenêtre latérale 112a et un deuxième élément détachable 120b est à son premier emplacement dans la deuxième fenêtre latérale 112b

Dans un mode de réalisation intéressant, le premier emplacement de chaque élément détachable est déterminé de sorte qu'il ne soit pas possible d'assembler, de monter, le boîtier sans avoir détaché au préalable tous les éléments détachables.

Une telle disposition permet ainsi d'éviter d'oublier un élément détachable.

La figure 2 présente par exemple plus en détail la partie encadrée « Il » représentée figure 1, montrant en outre un positionnement relatif d'une carte de circuits imprimés (PCB) 140 comportant par exemple des boutons 141 qui sont alors masqués par le deuxième élément détachable 120b.

Ainsi, tant que le deuxième élément détachable 120b n'est pas retiré, il n'est pas possible d'insérer la carte de circuits imprimés 140 ; en l'occurrence les boutons 141 ne peuvent pénétrer dans la fenêtre 112b correspondante.

Une zone obstruée par l'élément détachable évite donc par exemple de pouvoir monter la carte de circuits imprimés.

Il peut bien entendu en être de manière analogue pour le premier élément détachable.

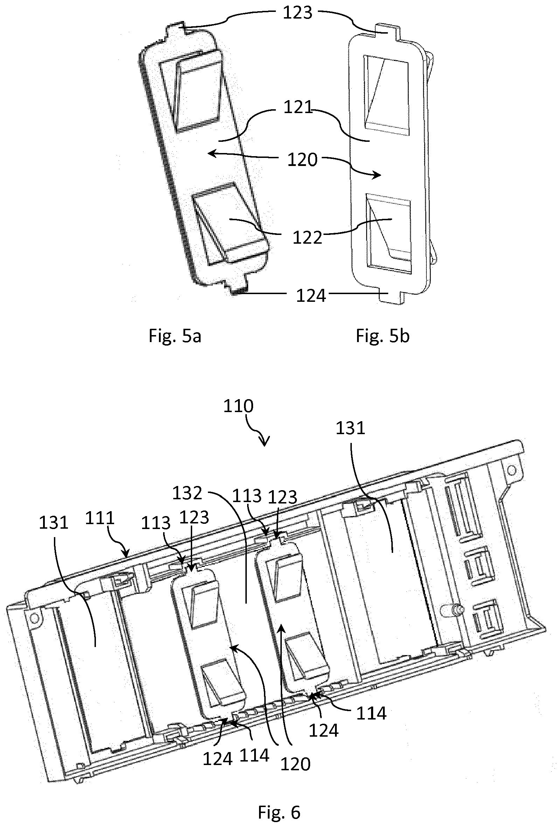

De plus, ici, chaque élément détachable 120, et en particulier une base 121 de l'élément détachable (indiquée figures 5a et 5b), occupe sensiblement toute une surface de la fenêtre dans laquelle il est positionné. Autrement dit, l'élément détachable obstrue la fenêtre correspondante.

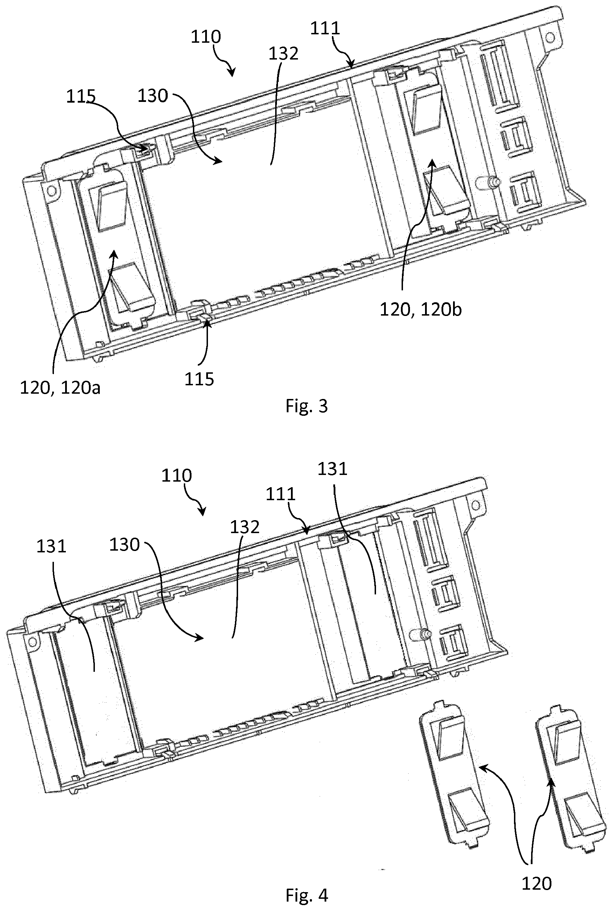

La figure 3 représente le support de la figure 1 du côté interne.

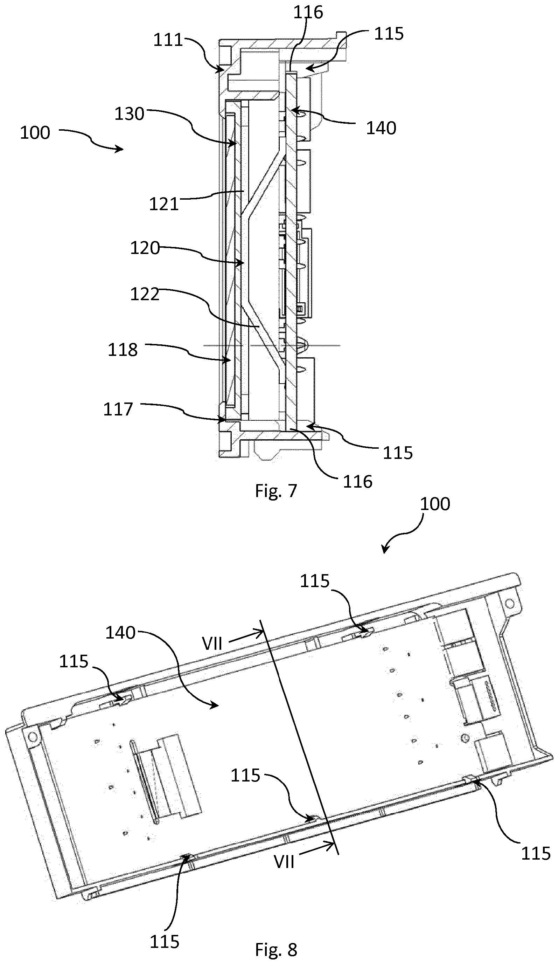

De ce côté interne, le cadre de référence 111 comporte par exemple un logement 117 (visible par exemple figure 7) configuré pour recevoir l'interface avec un utilisateur 130.

Le logement 117 présente par exemple une profondeur de préférence au maximum égale à une épaisseur de l'interface avec un utilisateur.

En particulier, le logement 117 configuré pour recevoir l'interface avec un utilisateur comporte ici une empreinte formée autour de la fenêtre centrale 112c configurée pour recevoir une partie de l'interface avec un utilisateur, par exemple ici l'écran 132, qui y est positionné.

Ainsi l'écran 132 est en vis-à-vis de la fenêtre centrale 112c et la figure 3 montre un dos de l'écran 132.

De manière analogue, la figure 4 représente le support du côté interne, avec les éléments détachables 120 qui ont été séparés du cadre de référence 111.

Le logement 117 configuré pour recevoir l'interface avec un utilisateur comporte ici deux autres empreintes, chacune étant formée autour d'une des fenêtres latérales 112a, 112b et étant configurée pour recevoir une autre partie de l'interface avec un utilisateur, par exemple alors un clavier 131. A titre illustratif, le présent exemple de réalisation comporte ainsi deux claviers 131, chacun étant disposé en vis-à-vis d'une fenêtre latérale 112a, 112b sur la figure 4. De même que pour l'écran 132, les claviers sont donc représentés de dos sur cette figure. Les claviers 131 représentés sur la figure 4 illustrent ici un exemple de réalisation non limitatif. On pourra, par exemple mettre en oeuvre l'invention avec un unique clavier ou aucun clavier, par exemple en utilisant un écran tactile. De plus, les claviers 131 peuvent se présenter sous la forme d'éléments indépendants ou être solidaires de la carte de circuits imprimés.

De manière générale, les figures 3 et 4 montrent ainsi que dans un mode de réalisation intéressant, il n'est donc pas possible de disposer intégralement l'interface utilisateur dans le support du boîtier tant que tous les éléments détachables n'ont pas été retirés du cadre de référence.

Ceci permet d'éviter d'oublier un élément détachable et limite ainsi les mauvais assemblages.

Les figures 5a et 5b présentent, vu respectivement de face et de dos, un élément détachable selon un exemple de réalisation privilégié.

L'élément détachable représenté est ici un élément de type ressort.

La base 121 par laquelle l'élément détachable est relié au cadre de référence dans le premier étant du support est ici une plaquette.

La plaquette a ici une forme sensiblement rectangulaire et une épaisseur sensiblement constante.

L'élément détachable de type ressort comporte en outre ici deux lames élastiques 122, disposées en miroir d'un même côté de la base 121. Chaque lame élastique comporte par exemple deux bords distincts, par exemple opposés, dont au moins l'un, et ici un seul, est relié à la plaquette. La lame élastique comporte en outre au moins une partie disposée à distance de la plaquette. En l'occurrence, il s'agit du bord opposé à celui par lequel la lame élastique 122 est relié à la plaquette. Une telle lame est parfois qualifiée de lame en attente. Ici, la lame élastique est sensiblement un élément plan disposé de manière oblique par rapport à la plaquette.

Ainsi, une telle disposition, en miroir, de deux lames élastiques, également qualifiable de disposition en ailes d'oiseau, permet de conférer un soutien de meilleure stabilité.

La figure 6 présente désormais le support 110, du côté interne, dans un deuxième état.

Dans le deuxième état, chaque élément détachable 120 est positionné à un deuxième emplacement, ménagé dans le cadre de référence 111 du support 110.

Pour faciliter un positionnement précis de chaque élément détachable, il est préférable que le support soit muni d'au moins un indicateur de positionnement, formant éventuellement un détrompeur, pour chaque élément détachable.

En l'occurrence, à cet effet, la base 121 d'un élément détachable comporte un premier décrochement à un bord périphérique de la base, par exemple un décrochement en excroissance 123, comme par exemple un ergot, un doigt ou un créneau, tel que représenté figures 5a et 5b par exemple, mais il pourrait également s'agir d'une entaille, comme un cran ou une rainure.

En contrepartie, le cadre de référence, pour définir le deuxième emplacement, comporte un décrochement complémentaire, par exemple en creux (comme un cran ou une rainure) s'il s'agit d'une excroissance, ou une excroissance (par exemple un doigt ou une nervure) si la base comporte une entaille.

Un décrochement en excroissance de la base peut aussi être assimilé à un tenon et coopérer avec une mortaise qui serait formée dans le cadre de référence pour définir au moins en partie le deuxième emplacement.

Dans le présent exemple de réalisation, la base comporte en outre ici un deuxième décrochement à un autre bord périphérique de la base, par exemple un bord opposé à celui où est situé le premier décrochement. Dans le présent exemple de réalisation, il s'agit également d'un deuxième décrochement en excroissance 124.

Dans l'exemple de la figure 6, les éléments détachables à leur deuxième emplacement sont positionnés derrière une partie de l'interface avec un utilisateur 130, en l'occurrence derrière l'écran 132.

En outre, la base 121 de chaque élément détachable 120 est ici plaquée contre le dos de ladite partie de l'interface avec un utilisateur.

Pour positionner chaque élément détachable 120, le cadre de référence comporte une première rainure 113 et une deuxième rainure 114, opposées l'une à l'autre de part et d'autre de la fenêtre 112 correspondante, avec lesquelles coopèrent une partie de la base d'un élément détachable, par exemple ici respectivement le premier décrochement en excroissance 123 et le deuxième décrochement en excroissance 124, en y étant posés.

En outre, la première rainure 113 et la deuxième rainure 114 sont ici formées au-delà du logement 117 ; autrement dit le logement 117 est défini entre les rainures. Il en serait de même pour tout autre type de décrochement du cadre de référence pour ne pas faire obstacle au positionnement d'au moins une partie de l'interface avec un utilisateur.

Une fois les éléments détachables 120 positionnés à leur deuxième emplacement, il est possible de mettre en place la carte de circuits imprimés 140.

Le boîtier comportant la carte de circuits imprimés en position est représenté en coupe sur la figure 7, la coupe étant établie selon l'axe VII-VII représenté figure 8.

Pour maintenir la carte de circuits imprimés 140, le cadre de référence 111 comporte un logement de réception d'une carte de circuits imprimés. Ce logement est ici formé par au moins un clip 115.

Un clip 115 est constitué d'un élément déformable élastiquement comportant une gorge 116 configurée pour y insérer la carte de circuits imprimés. Un tel clip a par exemple une forme de harpon, avec une gorge pour maintenir la carte de circuits imprimés à une distance préétablie par rapport à l'interface avec un utilisateur par exemple.

Ici, le cadre de référence 111 comporte plusieurs clips, en l'occurrence cinq clips comme le montre la figure 8, configurés pour agripper un rebord de la carte de circuits imprimés.

Dans le présent exemple de réalisation, chaque clip est formé intégralement dans le cadre de référence, c'est-à-dire de manière monobloc, en faisant sailli.

En position, la carte de circuits imprimés comprime les lames élastiques 122 de l'élément détachable 120 de type ressort, de sorte qu'au moins une partie de l'interface avec un utilisateur 130, ici l'écran 132, est maintenue plaquée contre le cadre de référence, et ce de manière particulièrement stable.

L'interface avec un utilisateur 130, les bases 121 des éléments détachables 120 et la carte de circuits imprimés 140 sont alors disposées sensiblement parallèlement.

L'interface avec un utilisateur 130 et la carte de circuits imprimés 140 sont ensuite électroniquement connectées, par exemple au moyen d'une nappe de connexion.

Optionnellement, une plaque transparente 118 peut être disposée au-dessus de l'interface avec un utilisateur 130, c'est-à-dire entre une partie d'une face avant de l'interface avec un utilisateur 130 et un fond du logement 117, comme le montre la figure 7.

Pour assembler un tel boîtier, sur chaine de montage, un opérateur détache les éléments détachables, par exemple de type ressort, du cadre de référence puis dispose au moins une partie d'une interface avec un utilisateur, par exemple un écran d'affichage, dans son logement et insère les éléments détachables, détachés, dans les emplacements destinés à les recevoir, c'est-à-dire leur deuxième emplacement, jusqu'à ce que ces derniers soient en appui plan contre la face arrière de ladite partie de l'interface avec un utilisateur, c'est-à-dire avec une base de l'élément détachable contre le dos d'une partie de l'interface avec un utilisateur.

L'opérateur insère ensuite la carte de circuits imprimés qui vient en appui, d'une part contre les lames élastiques et d'autre part contre les clips.

L'opérateur applique à la carte de circuits imprimés un effort pour déformer les lames élastiques et les clips, jusqu'à ce que la carte de circuits imprimés s'insère dans la gorge des clips et que ces derniers reprennent leur position initiale, naturelle.

L'interface avec un utilisateur et la carte de circuits imprimés sont ensuite électroniquement connectés, par exemple au moyen d'une nappe de connexion.

Ultérieurement, le boîtier est possiblement monté dans un appareil électroménager.

## Revendications

1. Boîtier (100) de commande et/ou d'affichage pour appareil électroménager comportant au moins un support (110) comportant un cadre de référence (111), le boîtier étant **caractérisé en ce que** :
- dans un premier état, le support comporte au moins un élément dit «détachable» (120), l'élément détachable comportant au moins une base (121) reliée, en un premier emplacement, au cadre de référence (111) par au moins un pont de matière formant une patte cassable, et **en ce que**
- dans un deuxième état, l'élément détachable (120) est positionné à un deuxième emplacement, ménagé dans le cadre de référence (111) du support, distinct du premier emplacement.

2. Boîtier selon la revendication 1, **caractérisé en ce que** le support (110) comporte au moins une fenêtre (112), configurée pour y positionner en vis-à-vis au moins une partie d'une interface avec un utilisateur (130), et le premier emplacement est ménagé dans ladite fenêtre (112).

3. Boîtier selon la revendication 2, **caractérisé en ce que** dans le premier état, ladite fenêtre (112) est obstruée par un ensemble de base, l'ensemble de base étant formé d'au moins la base (121) de l'au moins un élément détachable (120).

4. Boîtier selon l'une quelconque des revendications 1 à 3, **caractérisé en ce que** le premier emplacement d'au moins un élément détachable (120) est ménagé dans une partie d'un logement (117) de réception d'une interface avec un utilisateur et/ou dans une partie d'un logement de réception d'une carte de circuits imprimés, le premier emplacement étant ainsi configuré pour interdire un assemblage complet du boîtier (100) lorsqu'au moins un élément détachable (120) est à son premier emplacement.

5. Boîtier selon l'une quelconque des revendications 1 à 4, **caractérisé en ce que** le cadre de référence (111) comporte un décrochement (113, 114) configuré pour coopérer avec une partie d'un l'élément détachable (120), formant un indicateur de positionnement de l'élément détachable dans le cadre de référence à son deuxième emplacement.

6. Boîtier selon l'une quelconque des revendications 1 à 5, **caractérisé en ce que** l'élément détachable (120) est un élément ressort comportant une plaquette et au moins une lame élastique (122), la lame élastique étant reliée à la plaquette et ayant au moins une partie disposée à distance de la plaquette, la plaquette formant la base (121) de l'élément détachable (120).

7. Boîtier selon l'une quelconque des revendications 1 à 6, **caractérisé en ce que** le cadre de référence (111) comporte un logement de réception d'une carte de circuits imprimés, le logement étant formé par au moins un clip (115) constitué d'un élément déformable élastiquement comportant une gorge (116) configurée pour y insérer la carte de circuits imprimés (140).

8. Appareil électroménager **caractérisé en ce qu'**il comporte un boîtier (100) selon l'une quelconque des revendications précédentes.

9. Procédé d'assemblage d'un boîtier (100) selon l'une quelconque des revendications 1 à 7, comportant :
- une étape de fourniture d'un support (110) comportant un cadre de référence (111) et un élément détachable (120) par rapport au cadre de référence (111), l'élément détachable (120) étant relié au cadre de référence (111) par au moins un pont de matière formant une patte cassable ;
- une étape de détachement de chacun des au moins un élément détachable (120) du cadre de référence (111) ; et
- une étape d'insertion de chacun des au moins un élément détachable (120) dans un deuxième emplacement respectif ménagé dans le cadre de référence (111).

10. Procédé selon la revendication 9, comportant en outre, après l'étape de détachement de chacun des au moins un élément détachable (120) du cadre de référence (111) :
- une étape de disposition d'une interface avec un utilisateur (130) dans un logement (117) correspondant ménagé dans le cadre de référence (111) ; et
- une étape de placement d'une carte de circuits imprimés (140) dans un logement de réception d'une carte de circuits imprimés ménagé dans le cadre de référence (111) du support (110), au moins un élément détachable (120) étant positionné entre l'interface avec un utilisateur (130) et la carte de circuits imprimés (140).

## Patentansprüche

1. Steuer- und/oder Anzeigegehäuse (100) für ein elektrisches Haushaltsgerät, das zumindest einen Träger (110) mit einem Bezugsrahmen (111) enthält, wobei das Gehäuse **dadurch gekennzeichnet ist, dass**
- der Träger in einem ersten Zustand zumindest ein so genanntes "ablösbares" Element (120) enthält, wobei das ablösbare Element zumindest eine Basis (121) aufweist, die an einer ersten Stelle mit dem Bezugsrahmen (111) durch zumindest eine Materialbrücke verbunden ist, die eine wegbrechbare Lasche bildet, und dass
- das ablösbare Element (120) in einem zweiten Zustand an einer zweiten, in dem Bezugsrahmen (111) des Trägers vorgesehenen Stelle positioniert ist, die von der ersten Stelle verschieden ist.

2. Gehäuse nach Anspruch 1, **dadurch gekennzeichnet, dass** der Träger (110) zumindest ein Fenster (112) aufweist, das dazu ausgelegt ist, um darin zumindest einen Teil von einer Benutzerschnittstelle (130) gegenüberliegend zu positionieren, wobei die erste Stelle in dem Fenster (112) vorgesehen ist.

3. Gehäuse nach Anspruch 2, **dadurch gekennzeichnet, dass** das Fenster (112) im ersten Zustand von einer Basisanordnung verschlossen ist, wobei die Basisanordnung aus zumindest der Basis (121) des zumindest einen ablösbaren Elements (120) gebildet ist.

4. Gehäuse nach einem der Ansprüche 1 bis 3, **dadurch gekennzeichnet, dass** die erste Stelle zumindest eines ablösbaren Elements (120) in einem Abschnitt einer eine Benutzerschnittstelle aufnehmenden Aufnahme (117) und/oder in einem Abschnitt einer eine gedruckte Leiterplatte aufnehmenden Aufnahme vorgesehen ist, wobei die erste Stelle somit dazu ausgelegt ist, eine vollständige Montage des Gehäuses (100) zu verhindern, wenn sich zumindest ein ablösbares Element (120) an seiner ersten Stelle befindet.

5. Gehäuse nach einem der Ansprüche 1 bis 4, **dadurch gekennzeichnet, dass** der Bezugsrahmen (111) einen Absatz (113, 114) aufweist, der dazu ausgelegt ist, mit einem Abschnitt eines ablösbaren Elements (120) zusammenzuwirken, und der einen Indikator für die Positionierung des ablösbaren Elements in dem Bezugsrahmen an seiner zweiten Stelle bildet.

6. Gehäuse nach einem der Ansprüche 1 bis 5, **dadurch gekennzeichnet, dass** das ablösbare Element (120) ein Federelement ist, das eine Platte und zumindest ein Federblatt (122) umfasst, wobei das Federblatt mit der Platte verbunden ist und zumindest einen von der Platte entfernt angeordneten Abschnitt aufweist, wobei die Platte die Basis (121) des ablösbaren Elements (120) bildet.

7. Gehäuse nach einem der Ansprüche 1 bis 6, **dadurch gekennzeichnet, dass** der Bezugsrahmen (111) eine Aufnahme zum Aufnehmen einer gedruckten Leiterplatte aufweist, wobei die Aufnahme aus zumindest einer Klammer (115) gebildet ist, die aus einem elastisch verformbaren Element mit einer Nut (116) besteht, die dazu ausgelegt ist, die gedruckte Leiterplatte (140) darin einzusetzen.

8. Elektrisches Haushaltsgerät, **dadurch gekennzeichnet, dass** es ein Gehäuse (100) nach einem der vorstehenden Ansprüche enthält.

9. Verfahren zum Montieren eines Gehäuses (100) nach einem der Ansprüche 1 bis 7, umfassend:
- einen Schritt des Bereitstellens eines Trägers (110), der einen Bezugsrahmen (111) und ein vom Bezugsrahmen (111) ablösbares Element (120) enthält, wobei das ablösbare Element (120) mit dem Bezugsrahmen (111) durch zumindest eine Materialbrücke verbunden ist, die eine wegbrechbare Lasche bildet;
- einen Schritt des Ablösens jedes des zumindest einen ablösbaren Elements (120) von dem Bezugsrahmen (111); und
- einen Schritt des Einsetzens jedes des zumindest einen ablösbaren Elements (120) an einer jeweiligen zweiten Stelle, die in dem Bezugsrahmen (111) vorgesehen ist.

10. Verfahren nach Anspruch 9, ferner umfassend nach dem Schritt des Ablösens jedes des zumindest einen ablösbaren Elements (120) von dem Bezugsrahmen (111):
- einen Schritt des Anordnens einer Benutzerschnittstelle (130) in einer entsprechenden Aufnahme (117), die in dem Bezugsrahmen (111) vorgesehen ist; und
- einen Schritt des Einsetzens einer gedruckten Leiterplatte (140) in einer im Bezugsrahmen (111) des Trägers (110) vorgesehenen Aufnahme zum Aufnehmen einer gedruckten Leiterplatte, wobei zumindest ein ablösbares Element (120) zwischen der Benutzerschnittstelle (130) und der gedruckten Leiterplatte (140) positioniert ist.

## Claims

1. A control and/or display case (100) for a household appliance comprising at least one mounting (110) comprising a reference frame (111), the case being **characterized in that** that:
- in a first state, the mounting comprises at least one member referred to as "detachable" (120), the detachable member comprising at least one base (121) connected, at a first location, to the reference frame (111) by at least one bridge of material forming a frangible lug, and **in that**
- in a second state, the detachable member (120) is positioned at a second location, provided within the reference frame (111) of the mounting, that is distinct from the first location.

2. A case according to claim 1, **characterized in that** the mounting (110) comprises at least one window (112), configured for positioning there in a facing relationship at least part of a user interface (130), and the first location is provided in said window (112).

3. A case according to claim 2, **characterized in that** in the first state, said window (112) is blocked by a base assembly, the base assembly being formed by at least the base (121) of the at least one detachable member (120).

4. A case according to any one of claims 1 to 3, **characterized in that** the first location of at least one detachable member (120) is provided in part of a housing (117) for receiving a user interface and/or in a part of a housing for receiving a printed circuit board, the first location thus being configured to prevent full assembly of the case (100) when at least one detachable member (120) is in its first location.

5. A case according to any one of claims 1 to 4, **characterized in that** the reference frame (111) comprises a recess (113, 114) configured to cooperate with part of a detachable member (120), forming a positioning indicator for the detachable member in the reference frame at its second location.

6. A case according to any one of claims 1 to 5, **characterized in that** the detachable member (120) is a spring member comprising a plate and at least one elastic blade (122), the elastic blade being connected to the plate and having at least one part disposed at a distance from the plate, the plate forming the base (121) of the detachable member.

7. A case according to any one of claims 1 to 6, **characterized in that** the reference frame (111) comprises a housing for receiving a printed circuit board, the housing being formed by at least one clip (115) constituted by an elastically deformable member comprising a groove (116) configured for inserting therein the printed circuit board (140).

8. A household appliance, **characterized in that** it comprises a case (100) according to any one of the preceding claims.

9. A method of assembling a case (100) according to any one of claims 1 to 7, comprising:
- a step of providing a mounting (110) comprising a reference frame (111) and a detachable member (120) that is detachable relative to the reference fame (111), the detachable member (120) being connected to the reference frame (111) by at least one bridge of material forming a frangible lug;
- a step of detaching each at least one detachable member (120) from the reference frame (111); and
- a step of inserting each at least one detachable member (120) in a second respective location provided in the reference frame (111).

10. A method according to claim 9, further comprising, after the step of detaching each at least one detachable member (120) from the reference frame (111):
- a step of disposing a user interface (130) in a corresponding housing (117) provided in the reference frame (111); and
- a step of placing a printed circuit board (140) in a housing for receiving a printed circuit board provided in the reference frame (111) of the mounting (110), at least one detachable member (120) being positioned between the user interface (130) and the printed circuit board (140).
